# EUROPÄISCHE PATENTSCHRIFT

(11) **EP 0 774 887 B1**
(45) Veröffentlichungstag und Bekanntmachung des Hinweises auf die Patenterteilung: **18.08.2004**
(21) Anmeldenummer: 96117689.8
(22) Anmeldetag: 05.11.1996
(51) Int. Cl.: H05K 1/02, H01H 85/46

(54) **Montageplatine mit Leiterbahnsicherung und Verfahren zum Betrieb einer auf einer Montageplatine montierten elektrischen Schaltungsanordnung**
Mounting plate having circuit fuse and process for operating a circuit assembly mounted on a mounting plate
Platine de montage avec fusible à circuit et procédé de fonctionnement d'un assemblage de circuit monté sur une platine de montage

(30) Priorität: 16.11.1995 DE 19542783
(43) Veröffentlichungstag der Anmeldung: 21.05.1997
(73) Patentinhaber: Patent-Treuhand-Gesellschaft für elektrische Glühlampen mbH, 81543 München (DE)
(72) Erfinder: Orth, Klaus, Dr., 81543 München (DE); Raiser, Franz, 80689 München (DE)

(56) Entgegenhaltungen:
- DE-A- 3 723 832
- DE-A- 4 309 674
- DE-U- 1 862 872
- FR-A- 2 085 918
- FR-A- 2 246 970

## Beschreibung

Die Erfindung betrifft eine Montageplatine mit einer Leiterbahnsicherung gemäß dem Oberbegriff des Patentanspruchs 1.

Bekannt sind Montageplatinen mit darauf angebrachten elektrischen Leiterbahnen zur elektrischen Verbindung von auf der Montageplatine montierten Bauteilen, wobei zumindest eine Leiterbahn als Leiterbahnsicherung ausgebildet ist, die im Falle eines anomalen Betriebszustandes, insbesondere beim Auftreten eines elektrischen Kurzschlusses, die Verbindung zur elektrischen Spannungsquelle unterbricht (siehe z.B. DE-A-43 09 674 und FR-A-2085918). Diese als Sicherung ausgebildete Leiterbahn besitzt üblicherweise einen Bereich mit einem verengten Querschnitt, der beim Auftreten eines elektrischen Kurzschlusses abbrennt bzw. verdampft, so daß die Leiterbahn in diesem Bereich zerstört wird. Allerdings hat sich gezeigt, daß das beim Abbrand bzw. beim Verdampfen der Leiterbahnsicherung entstehende Plasma den Versorgungsstrom weiterhin trägt. Daher ist das Verhalten dieser Leiterbahnsicherung nicht kontrollierbar. Um im Falle eines Kurzschlusses eine sichere Abtrennung von der Versorgungsspannung zu gewährleisten, muß deshalb diese Leiterbahnsicherung noch durch eine weitere Sicherheitsmaßnahme ergänzt werden.

Es ist die Aufgabe der Erfindung, eine Montageplatine mit darauf angebrachten elektrischen Leiterbahnen bereitzustellen, die mit einer verbesserten Leiterbahnsicherung ausgestattet ist.

Diese Aufgabe wird erfindungsgemäß durch die Merkmale des Patentanspruchs 1 gelöst. Besonders vorteilhafte Ausführungen der Erfindung sind in den Unteransprüchen beschrieben.

Die erfindungsgemäße Montageplatine besitzt elektrische Leiterbahnen zum elektrischen Anschluß der auf der Montageplatine montierten Bauteile und ist mit einer Leiterbahnsicherung ausgestattet, die im Falle eines anomalen Betriebszustandes und insbesondere beim Auftreten eines elektrischen Kurzschlusses, die Verbindung zur Versorgungsspannung unterbricht. Erfindungsgemäß wird die Leiterbahnsicherung von zwei gegensinnig vom elektrischen Strom durchflossenen Leiterbahnabschnitten gebildet, die in einem so geringen Abstand nebeneinander angeordnet sind, daß die von diesen stromdurchflossenen Leiterbahnabschnitten ausgehenden Magnetfelder auf die in dem jeweils anderen Leiterbahnabschnitt fließenden elektrischen Ladungsträger einwirken. Der geringste Abstand zwischen den beiden Leiterbahnabschnitten der Leiterbahnsicherung beträgt höchstens 10 mm. Damit ist gewährleistet, daß die Stärke der vorgenannten Magnetfelder ausreicht, um die elektrischen Ladungsträger des Plasmas fortzuschleudern. Durch diese Maßnahme wird erreicht, daß ein Kurzschlußstrom durch das beim Abbrennen oder Verdampfen der Leiterbahnsicherung entstehende Plasma zuverlässig unterbunden wird, weil die elektrischen Ladungsträger dieses Plasmas durch die Wirkung der von den gegensinnigen elektrischen Strömen in den beiden Leiterbahnabschnitten der Leiterbahnsicherung erzeugten Magnetfelder aus dem Bereich der Leiterbahnsicherung entfernt werden. Außerdem verlaufen die beiden Leiterbahnabschnitte der Leiterbahnsicherung vorteilhafterweise parallel zueinander, so daß der Stromfluß in diesen beiden Leiterbahnabschnitten antiparallel ist. Dadurch wird die abstoßende Wirkung der obengenannten Magnetfelder auf die elektrischen Ladungsträger des Plasmas optimiert. Zumindest eine der beiden Leiterbahnabschnitte der Leiterbahnsicherung besitzt vorteilhafterweise einen Bereich mit einem verengten Querschnitt. Dieser Bereich der Leiterbahnsicherung wird im Falle eines elektrischen Kurzschlusses zuerst abbrennen bzw. verdampfen. Die Empfindlichkeit der Leiterbahnsicherung kann durch diesen verengten Bereich in gewissen Grenzen eingestellt werden.

Das erfindungsgemäße Betriebsverfahren für eine auf einer Montageplatine montierten elektrischen Schaltungsanordnung zeichnet sich durch eine aus zwei gegensinnig vom elektrischen Strom durchflossenen Leiterbahnabschnitten bestehende Leiterbahnsicherung aus, wobei diese Leiterbahnabschnitte in einem so geringen Abstand nebeneinander angeordnet sind, daß im Falle eines anomalen Betriebszustandes, insbesondere beim Auftreten eines elektrischen Kurzschlusses, zumindest ein Bereich der Leiterbahnsicherung zu einem Plasma verdampft und der Stromfluß im Plasma durch die Wechselwirkung der elektrischen Ladungsträger mit den Magnetfeldern, die von den in den Leiterbahnabschnitten der Leiterbahnsicherung fließenden Strömen erzeugt werden, unterbrochen wird. Diese Betriebsweise erlaubt es, auf bisher gebräuchliche Sicherheitsvorkehrungen, wie beispielsweise den Einbau einer handelsüblichen Schmelzsicherung, zu verzichten. Da die erfindungsgemäße Leiterbahnsicherung erheblich kostengünstiger als eine Schmelzsicherung ist, können durch deren Einsatz die Fertigungskosten gesenkt werden.

Nachstehend wird die Erfindung anhand eines bevorzugten Ausführungsbeispiels näher erläutert. Es zeigen:
- Figur 1: einen Ausschnitt aus dem Layout der erfindungsgemäßen Montageplatine gemäß des bevorzugten Ausführungsbeispiels
- Figur 2: eine Schaltskizze der auf der in Figur 1 abgebildeten Monatgeplatine montierten Bauteile

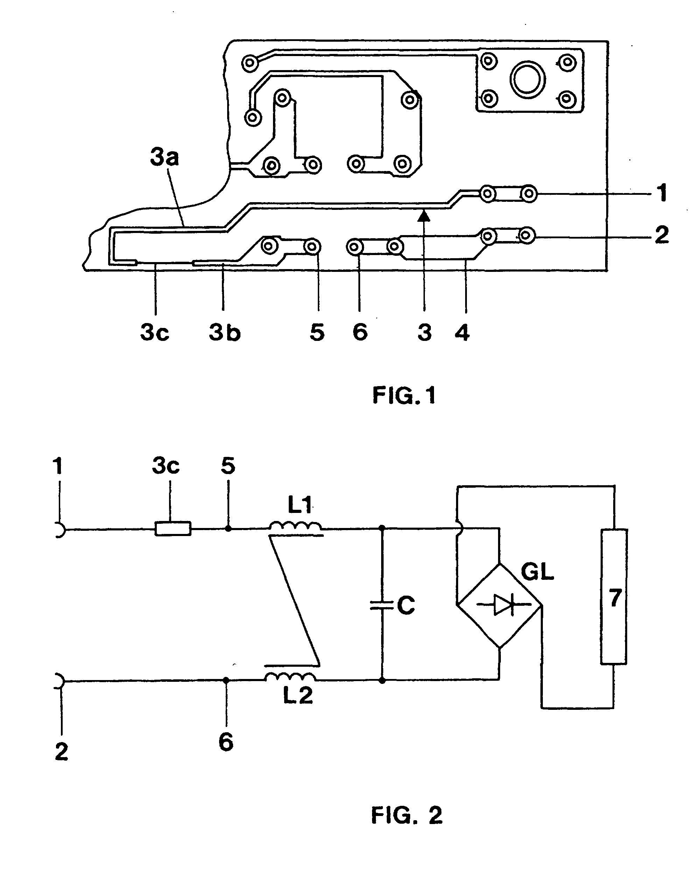

Die Montageplatine gemäß des bevorzugten Ausführungsbeispiels der Erfindung ist Bestandteil eines elektronischen Betriebsgerätes für elektrische Lampen. Sie ist mit elektrischen Leiterbahnen zur elektrischen Verbindung der auf der Montageplatine montierten Bauteile elektronischen Betriebsgerätes ausgestattet. In Figur 1 ist die Rückseite der Montageplatine mit den darauf angeordneten Leiterbahnen ausschnittweise abgebildet. Figur 2 zeigt die Schaltungsanordnung der auf der Montageplatine gemäß des bevorzugten Ausführungsbeispiels der Erfindung montierten Bauteile. Diese Bauteile sind Bestandteil eines elektronischen Vorschaltgerätes zum Betrieb von elektrischen Lampen.

Die erfindungsgemäße Montageplatine weist zwei Anschlüsse 1, 2 für eine Netzspannungsquelle auf. Zwischen den beiden Netzanschlüssen 1, 2 verlaufen zwei Leiterbahnen 3, 4. Die erste Leiterbahn 3 erstreckt sich vom ersten Netzanschluß 1 bis zu einem ersten Anschluß 5, während die zweite Leiterbahn 4 vom zweiten Netzanschluß 2 ausgeht und bei einem zweiten Anschlußpunkt 6 endet. Zwischen den beiden elektrischen Anschlüssen 5 und 6 ist der gesamte, mit der Netzspannung versorgte Lastkreis angeordnet, so daß die beiden Leiterbahnen 3, 4 während des Betriebes vom gesamten Versorgungsstrom durchflossen werden. Die erste Leiterbahn 3 ist als Leiterbahnsicherung ausgebildet. Sie besitzt zwei parallel nebeneinander verlaufende Leiterbahnabschnitte 3a, 3b, die gegensinnig, das heißt in Gegenrichtung oder antiparallel, vom Versorgungsstrom durchflossen werden. Der Abstand dieser beiden Leiterabschnitte voneinander beträgt ungefähr 3 mm. Der zweite Leiterbahnabschnitt 3b weist einen Bereich 3c mit einem verengten Querschnitt auf. Dieser verengte Bereich 3c des zweiten Leiterbahnabschnittes 3b erstreckt sich über eine Länge von ca. 6 mm. Die Breite des zweiten Leiterbahnabschnittes 3b beträgt ungefähr 1 mm, während die Breite des verengten Bereiches 3c nur ca. 0,2 mm mißt.

Die vom Versorgungsstrom durchflossenen, parallel nebeneinder verlaufenden Leiterbahnabschnitte 3a, 3c erzeugen jeweils ein Magnetfeld. Da die Flußrichtung des Versorgungsstromes in den beiden Leiterbahnabschnitten 3a, 3c antiparallel ist, übt das vom Leiterbahnabschnitt 3a ausgehende Magnetfeld auf die elektrischen Ladungsträger im Leiterbahnabschnitt 3c eine abstoßende Kraft aus. Umgekehrt übt auch das vom stromdurchflossenen Leiterbahnabschnitt 3c ausgehende Magnetfeld eine abstoßende Kraft auf die elektrischen Ladungsträger im Leiterbahnabschnitt 3a aus.

Im Falle eines anomalen Betriebszustandes, insbesondere beim Auftreten eines elektrischen Kurzschlusses, fließt durch die Leiterbahnsicherung 3a, 3c ein hoher Kurzschlußstrom, der zum Abbrennen bzw. zum Verdampfen des verengten Leiterbahnbereiches 3c führt. Das bei diesem Prozeß entstehende Plasma ist elektrisch leitend und würde daher den Kurzschlußstrom auch weiterhin tragen. Aber durch die abstoßende Wirkung des vom stromdurchflossenen Leiterbahnabschnitt 3a ausgehenden Magnetfeldes auf die elektrischen Ladungsträger des Plasmas werden diese Ladungsträger aus dem Bereich der Leiterbahnsicherung 3a, 3c entfernt und der Kurzschlußstrom zuverlässig unterbrochen. Die auf die elektrischen Ladungsträger des Plasmas wirkende abstoßende Kraft hängt quadratisch von der elektrischen Stromstärke und vom reziproken Abstand der beiden Leiterbahnabschnitte 3a, 3c ab. Sie ist während des Normalbetriebes, wegen der im Vergleich zum Kurzschlußstrom geringen Stromstärke des Normalbetriebes, bedeutungslos. Die Kurzschlußstromstärke liegt in der Größenordnung von 50 A und das auf die elektrischen Ladungsträger im Plasma einwirkende Magnetfeld besitzt beim Auftreten eines elektrischen Kurzschlusses eine Feldstärke von einigen Millitesla. Die Stromstärke des Versorgungsstromes ist im Normalbetrieb hingegen um zwei Größenordnungen kleiner als die Kurzschlußstromstärke.

Figur 2 zeigt in schematischer Darstellung eine bevorzugte Anwendung der erfindungsgemäßen Montageplatine auf ein Betriebsgerät für elektrische Lampen. An die Anschlüsse 5, 6 ist über die Wicklungen L1, L2 einer stromkompensierten Filterdrossel und über einen Filterkondensator C ein Brükkengleichrichter GL angeschlossen, dessen Gleichspannungsausgang mit einem Schaltnetzteil 7, beispielsweise mit einem Halbbrückenwechselrichter mit nachgeschaltetem LC-Ausgangskreis, in den zumindest eine Lampe geschaltet ist, verbunden ist

Die Erfindung beschränkt sich nicht auf das oben näher erläuterte Ausführungsbeispiel. Beispielsweise müssen die beiden Leiterbahnabschnitte 3a, 3c der Leiterbahnsicherung nicht unbedingt parallel verlaufen. Sie können auch einen spitzen Winkel miteinander bilden. Ferner ist es auch möglich, beide Leiterbahnabschnitte 3a, 3b der Leiterbahnsicherung mit einem querschnittsverengten Bereich 3c zu versehen.

## Patentansprüche

1. Montageplatine mit darauf angebrachten elektrischen Leiterbahnen zur elektrischen Verbindung von auf der Montageplatine montierten Bauteilen, wobei zumindest eine Leiterbahn (3) als Leiterbahnsicherung ausgebildet ist, die im Falle eines elektrischen Kurzschlusses, die Verbindung zur elektrischen Spannungsquelle (1, 2) unterbricht,
**dadurch gekennzeichnet, daß** die Leiterbahnsicherung aus zwei gegensinnig vom elektrischen Strom durchflossenen Leiterbahnabschnitten (3a, 3c) besteht, deren geringster Abstand höchstens 10 mm beträgt.

2. Montageplatine nach Anspruch 1, **dadurch gekennzeichnet, daß** die beiden Leiterbahnabschnitte (3a, 3b) der Leiterbahnsicherung parallel nebeneinander verlaufen und der Stromfluß in diesen Leiterbahnabschnitten (3a, 3b) antiparallel ist.

3. Montageplatine nach Anspruch 1, **dadurch gekennzeichnet, daß** zumindest einer der beiden Leiterbahnabschnitte (3b) der Leiterbahnsicherung einen Bereich (3c) mit einem verengten Querschnitt aufweist.

4. Elektrische Schaltungsanordnung mit einer Montageplatine gemäß Anspruch 1.

## Claims

1. Mounting plate having electrical conductor tracks fitted thereon for electrically connecting components mounted on the mounting plate, at least one conductor track (3) being in the form of a conductor track fuse, which, in the event of an electrical short circuit, interrupts the connection to the electrical voltage source (1, 2), **characterized in that** the conductor track fuse comprises two conductor track sections (3a, 3c), through which electrical current flows in opposing directions, the smallest spacing between said conductor track sections (3a, 3c) being at most 10 mm.

2. Mounting plate according to Claim 1, **characterized in that** the two conductor track sections (3a, 3b) of the conductor track fuse run adjacent and parallel to one another, and the current in these conductor track sections (3a, 3b) flows in parallel but in opposing directions.

3. Mounting plate according to Claim 1, **characterized in that** at least one of the two conductor track sections (3b) of the conductor track fuse has a region (3c) having a narrowed cross section.

4. Electrical circuit arrangement having a mounting plate according to Claim 1.

## Revendications

1. Carte de montage ayant des pistes conductrices électriques qui y sont appliquées en vue de la liaison électrique de composants montés sur la platine de montage, au moins une piste conductrice (3) étant conçue comme fusible de piste conductrice qui coupe la liaison vers la source de tension électrique (1, 2) en cas de court-circuit électrique,
**caractérisée par le fait que** le fusible de piste conductrice est constitué de deux tronçons de piste conductrice (3a, 3c) qui sont traversés en sens contraire par le courant électrique et dont le plus petit écart est de 10 mm au maximum.

2. Carte de montage selon la revendication 1, **caractérisée par le fait que** les deux tronçons de piste conductrice (3a, 3b) du fusible de piste conductrice s'étendent parallèlement l'un à côté de l'autre et que le flux de courant dans ces tronçons de piste conductrice (3a, 3b) est antiparallèle.

3. Carte de montage selon la revendication 1, **caractérisée par le fait qu'**au moins l'un des deux tronçons de piste conductrice (3b) du fusible de piste conductrice comporte une zone (3c) ayant une section transversale rétrécie.

4. Circuit électrique ayant une carte de montage selon la revendication 1.
